(19) Europäisches Patentamt
European Patent Office
Office européen des brevets

(11) **EP 2 600 125 B1**

(12) **FASCICULE DE BREVET EUROPEEN**

(45) Date de publication et mention
de la délivrance du brevet:
**20.04.2016 Bulletin 2016/16**

(51) Int Cl.:
***G01J 1/44*** *(2006.01)*

(21) Numéro de dépôt: **12354049.4**

(22) Date de dépôt: **26.11.2012**

(54) **Dispositif de détection de rayonnement à étendue d'illumination améliorée**

Vorrichtung zum Erfassen von Strahlung mit einem verbesserten Beleuchtungsbereich

Radiation-detection device with improved illumination range

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **29.11.2011 FR 1103631**

(43) Date de publication de la demande:
**05.06.2013 Bulletin 2013/23**

(73) Titulaire: **Société Française de Détecteurs
Infrarouges -
SOFRADIR
91120 Palaiseau (FR)**

(72) Inventeurs:
• **Maltere, Alexandre
38120 Saint-Egrève (FR)**

• **Rubaldo, Laurent
38600 Fontaine (FR)**

(74) Mandataire: **Talbot, Alexandre et al
Cabinet Hecké
Europole
10, rue d'Arménie - BP 1537
38025 Grenoble Cedex 1 (FR)**

(56) Documents cités:
**EP-A2- 2 302 341**

• **NICOLA ZANOLLA ET AL: "Reduction of RTS
Noise in Small-Area MOSFETs Under Switched
Bias Conditions and Forward Substrate Bias",
IEEE TRANSACTIONS ON ELECTRON DEVICES,
IEEE SERVICE CENTER, PISACATAWAY, NJ, US,
vol. 57, no. 5, 1 mai 2010 (2010-05-01), pages
1119-1128, XP011305632, ISSN: 0018-9383**

## Description

### Domaine technique de l'invention

L'invention concerne un dispositif de détection d'un rayonnement électromagnétique.

### État de la technique

Dans le domaine des dispositifs de détection, il y a communément un photodétecteur associé à un circuit de lecture. Le photodétecteur est polarisé dans une gamme particulière de potentiels de manière à délivrer un signal représentatif de la scène observée et ce signal est traité par le circuit de lecture pour être envoyé à un circuit d'analyse.

La polarisation du photodétecteur est obtenue au moyen du potentiel de substrat imposé sur une première borne du photodétecteur et au moyen d'un potentiel de référence imposé sur la seconde borne du photodétecteur. Par exemple, un dispositif de lecture de type amplificateur transimpédance capacitif permet d'imposer le potentiel de référence.

En fonction des conditions d'illumination subies, le photodétecteur délivre un courant plus ou moins important à un circuit de lecture qui intègre cette information. De cette manière, si le photodétecteur reçoit un rayonnement de faible intensité, il émet un signal électrique de faible intensité et si l'intensité du rayonnement croît, il en est de même du signal électrique émis par le photodétecteur.

Comme le signal électrique circulant dans le dispositif de détection est fonction de l'intensité du rayonnement électromagnétique initial, il est important de dimensionner les différents éléments formant le dispositif de détection afin de réduire autant que possible l'importance des signaux parasites et obtenir un rapport signal à bruit exploitable. L'obtention d'un rapport signal à bruit acceptable passe par exemple par un choix judicieux concernant le dimensionnement du circuit de lecture, notamment la valeur de la charge capacitive et les conditions d'alimentation appliquées aux différents éléments du dispositif de détection.

Le dispositif de détection est donc réalisé et/ou polarisé en fonction des conditions d'illumination attendues. Il en résulte que lorsque le rayonnement électromagnétique reçu est plus important que celui prévu, le photodétecteur génère un signal important qui sature les circuits électroniques du dispositif de détection. Le dispositif de détection devient complètement ébloui ou seulement partiellement ébloui si d'autres photodétecteurs sont encore en mesure de fournir une information représentative du flux lumineux reçu.

Les documents Zanolla et al, IEEE Transactions on Electron Devices, Vol. 57, No 5, p.1119-1127. May 2010 et EP 2302341 divulguent des circuits d'anti-éblouissement d'un photodétecteur.

### Objet de l'invention

On constate qu'il existe un besoin pour réaliser un dispositif de détection de rayonnement électromagnétique capable de fournir une information dans des conditions d'illumination variées.

On tend à combler ce besoin au moyen d'un dispositif selon les revendications annexées et plus particulièrement au moyen d'un dispositif selon la revendication 1.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

la figure 1 représente schématiquement un circuit de détection,
la figure 2 représente schématiquement un mode de réalisation particulier d'un circuit de détection selon la figure 1,
la figure 3 représente schématiquement un mode de réalisation particulier d'un comparateur selon la figure 2,
les figures 4a à 4f représentent schématiquement, des chronogrammes de différentes tensions à l'intérieur du circuit de détection.

### Description de modes particuliers de réalisation

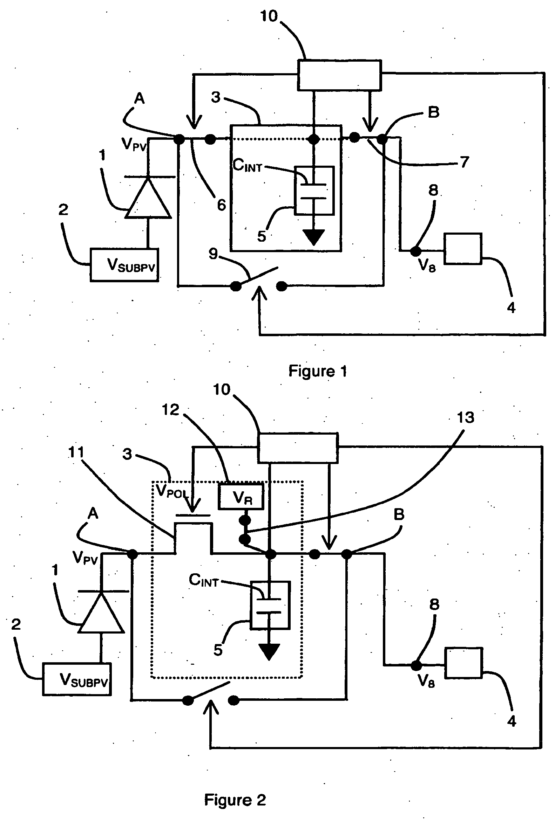

Comme cela est illustré à la figure 1, le dispositif de détection comporte au moins un pixel, de préférence une pluralité de pixels qui peuvent être organisés en une matrice. Un pixel comporte au moins un photodétecteur 1. Ainsi, le dispositif de détection comporte un photodétecteur 1, de préférence une pluralité de photodétecteurs 1 qui sont organisés, par exemple, en matrice.

Les photodétecteurs 1 peuvent être organisés selon un premier axe d'organisation X, c'est-à-dire que les photodétecteurs 1 forment une rangée ou une colonne selon ce premier axe X. Les photodétecteurs 1 sont alignés selon l'axe X avec un pas de répétition avantageusement constant.

Le photodétecteur 1 comporte une première borne et une deuxième borne. Le photodétecteur est polarisé de manière à fournir au circuit d'analyse une information sur la scène observée.

Le dispositif comporte un circuit de basculement du photodétecteur 1 entre des premier et deuxième modes de fonctionnement. Ce circuit de basculement est configuré pour faire travailler le photodétecteur 1 dans le premier mode de fonctionnement ou dans le deuxième mode de fonctionnement qui est différent du premier mode.

La polarisation du photodétecteur 1 est réalisée au moyen d'un circuit de polarisation qui peut être relié à chacune des bornes du photodétecteur 1. Le circuit de polarisation du photodétecteur 1 est configuré pour appliquer une première différence de potentiel aux bornes du photodétecteur 1 dans le premier mode de fonctionnement. Dans le premier mode de fonctionnement, la première différence de potentiel est imposée aux bornes du photodétecteur 1, ici par le potentiel de substrat $V_{SUBPV}$ et par le potentiel de référence $V_{REF}$. De manière avantageuse, le photodétecteur 1 est polarisé de manière à obtenir une conversion linéaire du flux électromagnétique reçu en un courant de porteurs de charge. Dans le cas particulier où le photodétecteur est une photodiode, cette dernière est polarisée, de préférence, sur le plateau de polarisation inverse.

Dans un premier mode de fonctionnement, le photodétecteur est polarisé au moyen d'une première différence de potentiel appliquée entre sa première borne et sa deuxième borne. La première borne est reliée électriquement à une première source de tension 2 délivrant une tension de polarisation $V_{SUBPV}$ (également appelée potentiel de substrat). La deuxième borne est reliée électriquement à une borne d'entrée d'un circuit de commande 3.

Selon les modes de réalisation, le circuit de commande 3 est configuré pour convertir le courant émis par le photodétecteur en une première grandeur électrique et/ou pour appliquer le potentiel de référence $V_{REF}$ sur sa borne d'entrée reliée au photodétecteur 1. De cette manière, le circuit de commande 3 intervient dans l'application de la première différence de potentiel aux bornes du photodétecteur 1 et donc dans l'obtention du premier mode de fonctionnement. Le potentiel de référence $V_{REF}$ est avantageusement choisi de manière à faire travailler le photodétecteur 1 dans un mode de conversion linéaire du flux électromagnétique reçu en un courant électrique. Le circuit de commande 3 agit comme un circuit de conversion, avantageusement linéaire, du signal en courant en un autre signal électrique.

La polarisation de la deuxième borne peut être réalisée par le circuit de commande 3 et/ou par un autre circuit (non représenté). Dans l'exemple illustré, le photodétecteur 1 est polarisé au moyen de la source de tension 2 et au moyen du circuit de commande 3.

Dans un mode de réalisation particulier, l'intégration de l'information émise par le photodétecteur 1 est réalisée au moyen du circuit de commande 3 qui peut alors comporter un condensateur d'intégration. Dans d'autres modes de réalisation, l'intégration et/ou le stockage de l'information est réalisé dans un circuit annexe (non représenté) qui peut être connecté en sortie du dispositif. Dans encore une autre variante de réalisation, l'intégration de l'information est réalisée dans le condensateur parasite du photodétecteur si ce dernier est une photodiode. Dans ce cas, le circuit de commande 3 réalise la polarisation de la photodiode pour la faire fonctionner en tant que Source Follower per Detector (SFD), la conversion et l'intégration du courant sont réalisées directement dans la photodiode 1.

Dans un mode de réalisation particulier, le photodétecteur 1 est formé sur un substrat en matériau semi-conducteur et la tension de polarisation $V_{SUBPV}$ est appliquée dans le substrat semi-conducteur par l'intermédiaire d'une ligne de polarisation connectée à la source de tension 2. La ligne de polarisation est une ligne en matériau électriquement conducteur, par exemple une ligne métallique qui court à la surface du substrat. Dans d'autres modes de réalisation, la ligne de polarisation est une zone dopée du substrat, cette zone est plus fortement dopée que le reste du substrat afin de diminuer la chute de potentiel le long de la ligne. De manière préférentielle, la ligne de polarisation est une zone dopée qui est du même type de conductivité que le substrat. Le substrat est d'un premier type de conductivité, par exemple de type P. Le type N est également possible.

De manière avantageuse, les photodétecteurs 1 sont des photodiodes et ils sont polarisés en inverse entre la tension de polarisation $V_{SUBPV}$ et la tension de référence $V_{REF}$ fournie par le circuit de commande 3. Cependant, il est également possible d'utiliser des photodétecteurs 1 à puits quantique ou à multi-puits quantiques (également appelés QWIP en anglais) en adaptant la différence de potentiel aux bornes du photodétecteur 1 pour avoir un signal électrique représentatif de la scène observée.

Le pixel comporte un photodétecteur 1 et son circuit de commande 3 associé. Le pixel est relié à un circuit d'analyse 4 par l'intermédiaire de sa borne de sortie 8. Le circuit de commande 3 est relié au circuit d'analyse 4 afin de pouvoir lui fournir l'information émise par le photodétecteur. De manière avantageuse, le circuit d'analyse 4 est relié à plusieurs pixels 1 et donc à plusieurs photodétecteurs de la matrice, par exemple une colonne ou une rangée de photodétecteurs de la matrice.

Le circuit de commande 3 comporte avantageusement une charge capacitive 5 qui est configurée pour recevoir les charges électriques émises par le photodétecteur 1 et former ainsi un circuit intégrateur. La charge capacitive 5 est chargée au moyen du courant délivré par le photodétecteur 1. Différentes architectures de circuits de commande 3 sont envisageables, par exemple des circuits de commande 3 à injection directe, à injection directe contreréactionnée, ou de type amplificateur trans-impédance capacitif. La charge capacitive 5 comporte au moins un condensateur d'intégration $C_{INT}$. Le courant émis par le photodétecteur est alors converti en une tension qui est de préférence proportionnelle au courant intégré.

Dans d'autres modes de réalisation la charge capacitive 5 est remplacée par une résistance ou par un autre élément.

Au moyen du potentiel de substrat $V_{SUBPV}$ et du potentiel de référence $V_{REF}$ appliqués sur les deux bornes du photodétecteur 1, ce dernier travaille dans le premier mode de fonctionnement qui convertit le flux électromagnétique reçu en un courant représentatif.

Dans le cas particulier illustré où le circuit de commande 3 comporte une charge capacitive 5, ce courant représentatif est intégré dans la charge capacitive 5. Le photodétecteur 1 fournit un signal en courant représentatif de la scène observée. Ce courant est transformé en une tension au moyen de la charge capacitive 5. Cette tension ou une valeur représentative de cette tension peut être présente sur la borne de sortie 8 du pixel afin d'être envoyée au circuit d'analyse 4.

La tension en sortie du circuit de commande 3 est représentative de la charge électrique accumulée dans le condensateur d'intégration $C_{INT}$ et donc de l'information en courant fournie par le photodétecteur 1 sur une période de temps donnée.

Le circuit de basculement du photodétecteur 1 est également configuré pour laisser une des bornes du photodétecteur 1 à un potentiel flottant dans le deuxième mode de fonctionnement. Dans le deuxième mode de fonctionnement, un potentiel est imposé sur une des bornes et l'autre potentiel est laissé flottant. La valeur finale de ce potentiel flottant permet de caractériser la scène observée. De manière avantageuse, le potentiel de substrat $V_{SUBPV}$ est appliqué comme dans le premier mode de fonctionnement ce qui permet de réaliser plus simplement la mesure du potentiel présent sur l'autre borne. Le potentiel flottant ou une valeur représentative de ce potentiel flottant peut être envoyé sur la borne de sortie 8 du pixel. Lorsque le photodétecteur fonctionne en circuit ouvert, c'est-à-dire qu'une de ces bornes n'est pas polarisée, le potentiel de cette borne est représentatif du flux lumineux reçu. La conversion de cette information n'est pas linéaire mais logarithmique ce qui permet d'étendre la dynamique de conversion.

La tension de circuit ouvert $V_{CO}$ de la photodiode peut être modélisée au moyen de l'équation suivante :

$$V_{CO} = \frac{nkT}{q} \ln\left(1 + \frac{I_\varphi}{I_{SAT}}\right) \text{ dans laquelle}$$

$I_\varphi$ représente le courant photogénéré par la photodiode,

$I_{SAT}$ représente le courant de saturation de la photodiode,

$T$ représente la température de la photodiode en Kelvin

$k$ représente la constante de Boltzmann,

$q$ représente une charge de l'électron en Coulomb

n représente le facteur d'idéalité de la photodiode.

Afin de réaliser le basculement entre le premier mode et le deuxième mode le circuit de basculement comporte un circuit de connexion/déconnexion du circuit de commande avec la borne de sortie 8 et le photodétecteur 1.

Le circuit de connexion/déconnexion du circuit de commande 3 est configuré pour connecter le circuit de commande 3, lorsque le photodétecteur 1 est dans le premier mode de fonctionnement et pour déconnecter le circuit de commande 3 lorsque le photodétecteur 1 est dans le deuxième mode de fonctionnement. De manière avantageuse, le circuit de connexion/déconnexion du circuit de commande 3 permet également de connecter ou de déconnecter le circuit de commande 3 avec la borne de sortie 8 du pixel.

Le circuit de basculement comporte également un interrupteur 9 qui relie le photodétecteur 1 à la borne de sortie 8 du pixel. L'interrupteur 9 est configuré pour être à l'état bloquant lorsque le photodétecteur 1 est dans le premier mode de fonctionnement et pour être à l'état passant lorsque le photodétecteur 1 est dans le deuxième mode de fonctionnement.

L'interrupteur 9 et le circuit de connexion/déconnexion du circuit de commande 3 sont avantageusement configurés pour être dans des états opposés de sorte que l'information émise par le photodétecteur 1 peut transiter entre deux voies distinctes pour atteindre la borne de sortie 8. Dans un premier cas de figure, le courant émis par le photodétecteur 1 arrive au circuit de commande 3 et il peut être intégré dans la charge capacitive 5. L'information intégrée dans la charge capacitive 5 est ensuite transmise à la borne de sortie 8. La valeur de ce potentiel ou une valeur qui en dérive est envoyée sur la borne de sortie 8.

Dans le deuxième mode de fonctionnement, le photodétecteur 1 fonctionne comme un générateur photovoltaïque. Dans ce mode de fonctionnement, l'élimination du courant représentatif de la scène observée est limitée à l'intérieur du dispositif de détection. Il y a augmentation de la tension aux bornes du photodétecteur et donc évolution du potentiel de la borne à potentiel flottant en fonction du flux lumineux reçu par le photodétecteur 1.

Ici, dans un mode de réalisation particulier, la tension de polarisation $V_{SUBPV}$ est toujours appliquée sur le photodétecteur 1, et la deuxième borne est laissée à un potentiel flottant. Dans ce cas de figure, les charges électriques émises sont en partie bloquées dans le photodétecteur et la valeur du potentiel présent sur la deuxième borne est utilisée pour caractériser la scène observée. La tension sur la deuxième borne évolue en fonction de l'intensité lumineuse reçue. Dans une variante de réalisation, la valeur du potentiel de substrat est différente entre les premier et deuxième modes de fonctionnement afin d'avoir plus de liberté dans la gestion de la dynamique de tension durant le deuxième mode de fonctionnement.

Le circuit de connexion/déconnexion du circuit de commande 3 peut être réalisé de différentes manières, par exemple au moyen d'un couple d'interrupteurs qui sont placés entre le photodétecteur et le circuit de commande et entre la borne de sortie et le circuit de commande. Ici un interrupteur est placé sur la borne d'entrée et un autre interrupteur est placé sur la borne de sortie du circuit de commande 3 afin de réaliser la connexion ou la déconnexion avec le photodétecteur 1 et avec la borne de sortie 8.

Un premier interrupteur 6 est disposé entre le photodétecteur 1 et le circuit de commande 3 de sorte que le courant émis par le photodétecteur 1 traverse le premier interrupteur 6 pour atteindre le circuit de commande 3 lorsque le premier interrupteur 6 est à l'état passant.

Un deuxième interrupteur 7 est disposé en sortie du circuit de commande 3 de sorte que l'information émise par le circuit de commande 3 vers la borne de sortie 8 du pixel traverse le deuxième interrupteur 7 lorsque ce dernier est à l'état passant.

Dans un mode de réalisation préférentiel car compact, le deuxième interrupteur 7 réalise la connexion directe entre la borne de sortie 8 du pixel et la borne de sortie du circuit de commande 3 qui est une des bornes de la charge capacitive 5. Il peut en être de même du premier interrupteur 6 qui possède une borne connectée directement au photodétecteur 1 et une autre borne connectée directement au circuit de commande 3.

Dans ce cas, l'interrupteur 9 peut être qualifié de troisième interrupteur 9 et il est monté en parallèle de l'ensemble formé par le premier interrupteur 6, le circuit de commande 3 et le deuxième interrupteur 7.

Dans un mode de réalisation préférentiel, le troisième interrupteur 9 définit un premier noeud électrique A avec une borne du photodétecteur 1 et une borne du premier interrupteur 6. Le troisième interrupteur 9 définit un deuxième noeud électrique B avec la borne de sortie 8 du pixel et une borne du deuxième interrupteur 7.

Le troisième interrupteur 9 est configuré pour être dans un état opposé au premier 6 interrupteur et avantageusement au deuxième 7 interrupteur. Les états opposés des premiers et deuxième interrupteurs permettent d'avoir le basculement entre les deux modes de fonctionnement sans perte de charges électriques durant le premier mode de fonctionnement. Cependant, selon la configuration du circuit, il est possible d'avoir les deux transistors à l'état passant.

Ainsi, lorsque le troisième interrupteur 9 est dans un état passant, les premier 6 et deuxième 7 interrupteurs sont dans un état bloquant. Lorsque le troisième interrupteur 9 est dans un état bloquant, les premier 6 et deuxième 7 interrupteurs sont dans un état passant.

Il en résulte que lorsque le troisième interrupteur 9 est dans un état passant, la borne de sortie 8 est reliée à la deuxième borne du photodétecteur 1. Dans ce cas, la borne de sortie 8 est au potentiel flottant du photodétecteur 1 et cette information est transmise au circuit d'analyse 4. Le photodétecteur 1 délivre directement une information « en tension » sur la scène observée. Lorsque le premier interrupteur 6 et le deuxième interrupteur 7 sont dans un état passant, la borne de sortie 8 du pixel est reliée à la borne de sortie du circuit de commande 3. Le circuit de commande 3 délivre sur la borne de sortie 8 du pixel une tension qui est représentative du courant délivré par le photodétecteur 1. Le photodétecteur délivre une information « en courant » sur la scène observée qui est transformée en une information « en tension », par le circuit de commande 3.

Lorsque le courant délivré par le photodétecteur 1 est très important, le circuit de commande 3 sature et la tension en sortie du condensateur $C_{INT}$ n'est plus représentative de l'information envoyée par le photodétecteur 1. Ce cas de figure peut intervenir lorsque le circuit de commande 3 comporte ou est couplé à un circuit d'anti-éblouissement qui évacue les charges excédentaires provenant du photodétecteur 1. Le circuit d'anti-éblouissement se met en fonctionnement lorsque la différence de potentiels aux bornes de la charge capacitive 5 atteint une valeur seuil.

Il est également possible que l'information intégrée ne soit plus représentative de la scène observée lorsque les conditions de polarisation du photodétecteurs 1 sont décalées, par exemple à cause d'une différence de potentiels trop importante aux bornes du condensateur $C_{INT}$ ce qui fait évoluer la tension de référence $V_{REF}$ imposée sur le photodétecteur 1 par le circuit de commande 3.

Dans ces deux cas de figure, le pixel n'est plus en mesure de donner une information représentative de la scène observée car les différentes conditions d'illumination sont plus importantes que ce qui a été prévu.

Afin de conserver une information sur les conditions d'illumination du photodétecteur 1, le dispositif comporte un comparateur 10 des conditions de polarisation aux bornes de la charge capacitive 5 par rapport à une valeur seuil $V_{SEUIL}$.

Selon que la valeur mesurée est inférieure ou supérieure à la valeur seuil $V_{SEUIL}$, le comparateur 10 émet un premier signal ou un deuxième signal sur sa borne de sortie. Le premier signal est différent du deuxième signal.

Dans un mode de réalisation particulier, le comparateur 10 réalise la mesure de la tension aux bornes de la charge capacitive 5, ici par exemple aux bornes du condensateur d'intégration $C_{INT}$. Dans une variante de réalisation, le comparateur 10 réalise la mesure de la tension sur la sortie du circuit de commande 3. Dans un mode de réalisation préférentiel, une des bornes de la charge capacitive 5 est connectée à un circuit imposant un potentiel fixe, par exemple la masse ou une autre tension spécifique du dispositif de détection. Dans ce cas, la mesure des conditions aux bornes de la charge capacitive 5 peut être réalisée au moyen de la mesure du potentiel présent sur l'autre borne, c'est-à-dire la borne qui n'est pas à un potentiel fixe. Cette autre borne peut être la borne de sortie du circuit de commande 3 ou une autre borne du circuit de commande 3.

De manière plus générale, la mesure de tension peut être réalisée sur un noeud électrique dont le potentiel varié en fonction de la quantité d'énergie intégrée dans la charge capacitive 5, donc en fonction de la différence de potentiel qui existe aux bornes de la charge capacitive 5.

Le comparateur 10 est relié au circuit de connexion/déconnexion et à l'interrupteur 9. Les états passant et bloquant de l'interrupteur 9 et du circuit de connexion/déconnexion sont définis en fonction du signal émis par le comparateur 10, donc en fonction du résultat de la comparaison.

Dans l'exemple de la figure 1, la borne de sortie du comparateur 10 est reliée aux bornes de commande du premier interrupteur 6, du deuxième interrupteur 7 et du troisième interrupteur 9.

Les interrupteurs 6, 7 et 9 sont configurés de sorte que tant que la tension aux bornes de la charge capacitive 5 n'a pas atteint la valeur seuil $V_{SEUIL}$, le comparateur 10 délivre le premier signal ce qui se traduit par un état passant pour les premier 6 et deuxième 7 interrupteurs et par un état bloquant pour le troisième interrupteur 9. Selon les conditions de polarisation, le premier signal peut être émis si la tension aux bornes de la charge capacitive 5 est inférieure ou supérieure à la valeur seuil $V_{SEUIL}$.

Lorsque la tension aux bornes de la charge capacitive 5 atteint la valeur seuil ou la dépasse, le comparateur 10 délivre le deuxième signal ce qui se traduit par un état bloquant pour les premier 6 et deuxième 7 interrupteurs et par un état passant pour le troisième interrupteur 9. Le basculement permet d'éviter la dépolarisation de la photodiode puis la saturation du circuit de lecture lorsque le flux devient trop important.

De cette manière, selon la quantité de charges électriques intégrée dans la charge capacitive 5, le pixel envoie une information « en courant » ou une information « en tension » au circuit d'analyse 4. La dénomination « en courant » ou «en tension » représente le mode de fonctionnement du photodétecteur 1.

Alors que dans l'art antérieur, un pixel ébloui ne donnait plus d'information sur l'état de la scène observée, cette architecture est en mesure de donner une autre information qui reste représentative de la scène observée.

L'information « en tension » provient d'un autre mode de fonctionnement du photodétecteur. Dans ce second mode de fonctionnement, le photodétecteur fonctionne comme une pile photovoltaïque, la polarisation aux bornes du photodétecteur 1 est liée à ses conditions d'illumination. L'information est de type logarithmique en fonction du flux lumineux reçu ce qui se traduit par une compression de l'échelle de conversion qui existe entre le flux lumineux reçu et le signal électrique émis. Cette compression permet de travailler sur une échelle de flux lumineux beaucoup plus importante. Comme l'illumination est importante dans le deuxième mode de fonctionnement, le rapport signal à bruit reste important même si le circuit d'analyse n'est pas obligatoirement configuré pour un fonctionnement optimal dans cette gamme de tensions.

Même si il est difficile de comparer l'information délivrée dans le deuxième mode de fonctionnement avec les valeurs de l'information délivrée durant le premier mode de fonctionnement, il est possible de comparer deux conditions d'illumination de deux photodétecteurs fonctionnant dans le même mode de fonctionnement. Il est également possible de comparer un même photodétecteur donnant deux informations différentes dans le temps pour un même mode de fonctionnement.

Cette architecture permet, de manière simple, de modifier l'échelle de conversion qui existe entre le flux lumineux reçu et le signal électrique émis afin de s'adapter aux conditions d'illuminations reçues. Dans le premier mode de fonctionnement, le photodétecteur délivre un courant qui est représentatif de la scène observée, de préférence un courant proportionnel à la scène observée ce qui permet une analyse fine.

Dans le deuxième mode de fonctionnement, les conditions d'illumination sont plus fortes, le courant à gérer est trop important et il est choisi de travailler sur une plage d'illumination plus étendue en analysant la tension présente aux bornes du photodétecteur 1.

Le passage des premier 6 et deuxième 7 interrupteurs à l'état bloqué lorsque la valeur seuil $V_{SEUIL}$ est atteinte permet d'éviter la décharge de la charge capacitive 5 dans le pixel ce qui fausserait la valeur de l'information en tension. Il en va de même de l'état bloqué du troisième interrupteur 9 avant que la valeur seuil $V_{SEUIL}$ ne soit atteinte, ce qui évite la perte d'une partie des charges électriques émises par le photodétecteur 1 qui ne seraient pas intégrées dans la charge capacitive 5 car elles partiraient vers la sortie 8 du pixel et vers le circuit d'analyse 4. Cette synchronisation des interrupteurs est avantageuse pour avoir la meilleure sensibilité d'information, mais un décalage dans le temps n'empêche pas d'avoir un basculement entre le premier mode et le deuxième mode de fonctionnement.

Dans un mode de réalisation préférentiel illustré à la figure 2, le circuit de commande 3 est de type « injection directe », c'est-à-dire qu'un transistor de polarisation 11 est connecté entre la charge capacitive 5 et le photodétecteur 1. La polarisation appliquée sur l'électrode de grille du transistor de polarisation 11 permet de définir la tension de référence $V_{REF}$ imposée sur la borne du photodétecteur 1.

L'électrode de grille du transistor de polarisation 11 est couplée au comparateur 10 de sorte qu'une première tension de grille est appliquée sur l'électrode de grille lorsque la tension aux bornes de la charge capacitive 5 n'a pas atteint la valeur seuil et qu'une deuxième tension de grille est appliquée sur l'électrode de grille lorsque la tension aux bornes de la charge capacitive 5 atteint la valeur seuil. Les deux tensions de grille appliquées sur le transistor de polarisation 11 peuvent représenter le premier signal et le deuxième signal émis par le comparateur 10. Cependant, la différence entre le premier signal et le deuxième signal peut être également une différence en courant ou sur un autre paramètre, par exemple la fréquence. Un circuit de conversion peut alors être utilisé entre la sortie du comparateur 10 et l'électrode de grille.

Lorsque la première tension de grille est appliquée, le transistor de polarisation 11 est à l'état passant et les charges émises par le photodétecteur 1 sont transférées au circuit de commande 3 qui intègre l'information dans la charge capacitive 5. Lorsque la deuxième tension de grille est appliquée, le transistor de polarisation 11 est à l'état bloqué.

Le transistor de polarisation 11 peut être assimilé au premier interrupteur 6 car il empêche ou autorise un transit des charges électriques entre le photodétecteur 1 et la charge capacitive 5. Dans ce mode de réalisation, le transistor de polarisation 11 du circuit de commande 3 fait également partie du circuit de connexion/déconnexion. Dans le cas où le potentiel appliqué sur l'électrode de grille du transistor 11 provient directement ou indirectement du comparateur, le premier interrupteur 6 est avantageusement le transistor de polarisation 11.

Dans un mode de réalisation particulier et très compact, la deuxième borne du photodétecteur 1 est connectée à une première borne du transistor de polarisation 11 et à la première borne du troisième interrupteur 9 pour former le noeud électrique A. La deuxième borne du transistor de polarisation 11 est connectée à une première borne du condensateur d'intégration $C_{INT}$. Le deuxième interrupteur 7, le troisième interrupteur 9 et la borne de sortie 8 du pixel sont connectés ensemble pour former le deuxième noeud électrique B.

La deuxième borne du condensateur de d'intégration $C_{INT}$ est reliée à un potentiel fixe (ici la masse) provenant d'un circuit de polarisation. Le comparateur 10 réalise la mesure du potentiel présent sur la première borne du condensateur $C_{INT}$ afin de suivre l'évolution du potentiel au fur et à mesure de la charge du condensateur d'intégration $C_{INT}$ à partir du courant délivré par le photodétecteur 1.

Une deuxième source de tension 12 peut être utilisée pour délivrer une tension de remise à zéro $V_R$ de la charge capacitive 5. La deuxième source de tension 12 est reliée à la première borne du condensateur d'intégration $C_{INT}$ par l'intermédiaire d'un quatrième interrupteur 13. Lorsque le quatrième interrupteur 13 est à l'état passant, le condensateur d'intégration est remis à zéro. La remise à zéro de la charge capacitive peut également être réalisée par d'autres circuits.

Comme le comparateur 10 est relié à différents éléments du dispositif de détection, il est avantageux de prévoir plusieurs bornes de sortie qui délivrent chacune un premier signal et un deuxième signal dans des gammes différentes de tension. A titre d'exemple, la tension $V_{POL}$ appliquée sur l'électrode de grille du transistor de polarisation 11 peut être différente de la tension appliquée sur le deuxième et/ou sur le troisième interrupteurs.

Le comparateur 10 peut comporter une sortie délivrant le premier signal et le deuxième signal. Cette sortie peut être reliée à un circuit de dérivation couplé à un circuit de modification des niveaux de tension. De cette manière, le signal émis par le comparateur 10 est transformé en une pluralité de signaux qui sont avantageusement en phase. Les différents signaux peuvent être alors dans des gammes de tension différentes.

Dans une variante de réalisation, le circuit de dérivation est intégré au comparateur 10 et le circuit de modification des niveaux de tension peut également être intégré au comparateur.

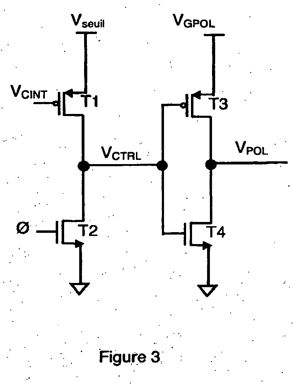

A titre d'exemple, la figure 3 représente un mode de réalisation particulier de comparateur 10. Le comparateur 10 comporte un premier transistor T1 et un deuxième transistor T2 montés en série. Les deux transistors sont montés en série entre la tension de seuil $V_{SEUIL}$ et une tension fixe du circuit qui est la masse ou la tension d'alimentation Vdd. Les deux transistors T1 et T2 sont de types opposés. Dans l'exemple particulier de la figure 3, les deux transistors T1 et T2 sont connectés entre la masse et la valeur de seuil $V_{SEUIL}$. Le transistor T1 est de type PMOS et connecté à la tension de seuil $V_{SEUIL}$. Le transistor T2 est connecté à la masse et il est de type NMOS. La tension de seuil est appliquée au moyen d'une source de tension additionnelle (non représentée).

La tension mesurée par le comparateur 10 est appliquée sur l'électrode de grille du transistor connecté à la source de tension additionnelle délivrant la tension de seuil $V_{SEUIL}$. L'autre électrode de grille reçoit un signal de remise à zéro Ø de la charge capacitive 5.

La borne commune des transistors T1 et T2 délivre un signal $V_{CTRL}$ représentatif de la comparaison de la tension aux bornes de la charge capacitive 5 par rapport à la valeur seuil $V_{SEUIL}$. Dans l'exemple illustré, le signal $V_{CTRL}$ est égal à la masse tant que la tension $V_{CINT}$ est supérieure à la valeur seuil $V_{SEUIL}$ (moins la tension de seuil du transistor T1). Une fois que la tension $V_{CINT}$ devient égale à la tension $V_{SEUIL}$, le signal $V_{CTRL}$ devient égal à la valeur seuil $V_{SEUIL}$. La tension $V_{CTRL}$ présente deux états distincts représentatifs du premier signal et du deuxième signal.

Un fonctionnement opposé peut être obtenu en remplaçant la masse par la polarisation Vdd et en remplaçant les transistors NMOS par des transistors PMOS et inversement.

Le signal $V_{CTRL}$ est connecté aux électrodes de grille de deux autres transistors, les transistors T3 et T4. Le troisième transistor T3 et le quatrième transistor T4 sont connectés en série. Le troisième transistor est d'un type opposé au quatrième transistor. Dans l'exemple illustré, les transistors T3 et T4 sont connectés en série entre la première tension et la deuxième tension de polarisation de l'électrode de grille du transistor de polarisation 11. Dans l'exemple illustré à la figure 3, la première tension de polarisation est la tension $V_{GPOL}$ et la deuxième tension de polarisation est la masse. La borne commune des transistors T3 et T4 est reliée à l'électrode de grille du transistor de polarisation 11 qui est ici de type NMOS.

Les transistors T3 et T4 forment un circuit de décalage des niveaux de tension associés au premier signal et au deuxième signal.

De cette manière, selon le résultat de la comparaison entre la tension de seuil $V_{SEUIL}$ et la tension aux bornes du condensateur d'intégration $C_{INT}$, la première ou la deuxième tension de polarisation est appliquée sur l'électrode de grille du transistor 11.

La borne commune des transistors T3 et T4 délivre un signal $V_{POL}$ qui est appliqué sur l'électrode de grille du transistor de polarisation 11. De cette manière, il est possible d'obtenir simplement et de manière compacte, un comparateur 10 qui est capable de délivrer un signal compatible avec les conditions de polarisation de l'électrode de grille du transistor 11. Ce circuit permet de modifier la gamme de tension accessible entre le signal $V_{CTRL}$ et la tension appliquée sur le transistor de polarisation 11.

Une intégration identique peut être réalisée pour faire basculer les interrupteurs 7 et 9. Il suffit pour cela de dupliquer le deuxième groupe de transistors T3 et T4, de leurs imposer le signal $V_{CTRL}$ et de modifier les conditions d'alimentation. Un second circuit de décalage des niveaux de tension est réalisé par exemple entre la tension Vdd et la masse. La sortie de ce second circuit de décalage est envoyée sur l'électrode de grille des interrupteurs 7 et 9.

Dans une variante de réalisation, il est avantageux de former l'interrupteur 7 et/ou l'interrupteur 9 par deux transistors montés en parallèle. Les deux transistors sont de types opposés. Ainsi, le transistor NMOS reçoit un signal et le transistor PMOS reçoit le signal complémentaire.

Si le basculement des transistors 7 et 9 est simultané, il est avantageux d'appliquer le même signal sur le transistor NMOS de l'interrupteur 7 et sur le transistor PMOS de l'interrupteur 9. Le signal complémentaire est alors appliqué sur le transistor NMOS de l'interrupteur 9 et sur le transistor PMOS de l'interrupteur 7.

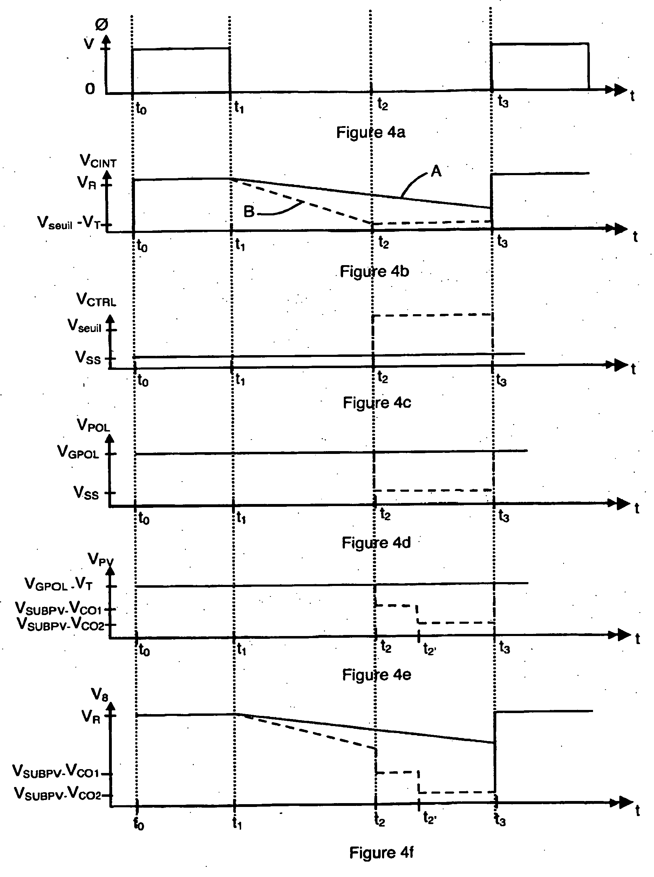

Les figures 4a à 4f représentent différents chronogrammes d'éléments caractéristiques du dispositif de détection. La figure 4a représente le signal de remise à zéro 0 de la charge capacitive, ce qui permet de définir la durée d'intégration et la période de rafraîchissement du circuit. A un instant $t_0$, le signal Ø passe le quatrième interrupteur 13 à l'état passant ou un autre circuit de manière à remettre à zéro le condensateur d'intégration. La remise à zéro a lieu entre les instants $t_0$ et $t_1$. L'intégration de la scène observée a lieu entre les instants $t_1$ et $t_3$. A l'instant $t_3$, un nouveau cycle d'intégration commence avec une phase de remise à zéro de la charge capacitive 5.

La figure 4b représente la tension aux bornes de la charge capacitive 5 dans deux conditions d'illumination différentes illustrées par les courbes A et B. la figure 4c représente la tension $V_{CTRL}$ émise en sortie du comparateur 10 pour les deux conditions d'illumination.

La figure 4d représente la tension appliquée sur l'électrode de grille du transistor de polarisation 11. La figure 4f représente l'évolution de la valeur du potentiel $V_{PV}$ de la deuxième borne du photodétecteur. La figure 4g représente l'évolution de la valeur du potentiel $V_8$ sur la borne de sortie 8.

Comme cela est illustré sur la figure 4b, la courbe A (trait plein) correspond à une première condition d'illumination pour laquelle la tension aux bornes de la charge capacitive n'atteint pas la tension seuil $V_{SEUIL}$ à la fin de la période d'intégration $t_3$. Dans le cas de la courbe A, la tension $V_{CINT}$ est toujours supérieure à la tension $V_{SEUIL}$ -$V_T$ entre les instants $t_1$ et $t_3$. L'illumination est considérée constante ce qui entraine une évolution constante de la tension aux bornes du condensateur d'intégration $C_{INT}$.

A l'instant $t_3$, comme la tension aux bornes de la chargé capacitive reste supérieure à la valeur seuil, ici la tension de seuil injectée par la source de tension additionnelle moins la tension de seuil $V_T$ du transistor 13 (figure 4b), le comparateur 10 ne change pas d'état et le premier signal, ici la tension $V_{SS}$, est émis par le comparateur 10 durant toute la durée d'intégration (entre les instants $t_1$ et $t_3$) comme cela est illustré à la figure 4c. La tension $V_{POL}$ appliquée sur la grille du transistor de polarisation 11 est constante sur toute la durée d'intégration et elle est égale à la tension $V_{GPOL}$ comme cela est illustré sur la figure 4d.

La tension $V_{PV}$ présente sur la deuxième borne du photodétecteur 1 est égale à $V_{GPOL}$-$V_T$, c'est-à-dire la tension appliquée sur l'électrode de grille du transistor de polarisation 11 moins la tension de seuil de ce dernier (figure 4e).

Dans l'exemple illustré, les tensions $V_{CTRL}$, $V_{POL}$ et $V_{PV}$ sont constantes entre les instants $t_0$ et $t_3$.

L'information envoyée par le pixel correspond à la tension présente sur la borne de sortie 8 qui correspond ici à la tension fixe $V_R$ appliquée sur une des bornes du condensateur $C_{INT}$ moins l'intégrale du courant d'intégration sur la durée d'intégration (ici $I*(t_3-t_1)$) divisé par la valeur de capacité électrique de la charge capacitive (figure 4f) soit $V_R - I*(t_3-t_1)/C_{INT}$. La valeur de la tension $V_8$ évolue à partir de l'instant $t_1$ au fur et à mesure du courant délivré par le photodétecteur.

Lorsque le courant émis par le photodétecteur est plus important (courbe B des figures 4b à 4f, pointillés), la tension aux bornes de la charge capacitive atteint la valeur seuil comme cela est visible sur la figure 4b. A l'instant $t_2$, la tension aux bornes de la charge capacitive atteint la valeur seuil. Entre les instants $t_1$ et $t_2$, le fonctionnement est identique à celui décrit pour la courbe A.

Entre les instants $t_1$ et $t_2$, le comparateur 10 envoie le premier signal depuis sa borne de sortie. A partir de l'instant $t_2$ et jusqu'à l'instant $t_3$, le comparateur 10 envoie maintenant le deuxième signal, ici le signal $V_{SEUIL}$ (figure 4c).

De ce fait, une première tension de polarisation, la tension $V_{GPOL}$ est appliquée sur l'électrode de grille du transistor de polarisation 11 entre les instants $t_0$ et $t2$. Une deuxième tension de polarisation est appliquée (ici $V_{SS}$) à partir de l'instant $t_2$ jusqu'à l'instant $t_3$ (figure 4d). Le transistor de polarisation 11 devient bloquant à partir de l'instant $t_2$.

Entre les instants $t_1$ et $t_2$, la tension appliquée sur la deuxième borne du photodétecteur est égale à $V_{GFOL}-V_T$ comme dans le cas de la courbe A. A partir de l'instant $t_2$ jusqu'à l'instant $t_3$, la tension présente sur la deuxième borne du photodétecteur est égale à la tension appliquée sur la première électrode moins la tension de circuit ouvert $V_{CO}$ liée aux conditions d'illumination du photodétecteur. Dans l'exemple illustré, une première condition d'illumination est appliquée entre les instants $t_2$ et $t_{2'}$. Une deuxième condition d'illumination est appliquée entre les instants $t_{2'}$ et $t_3$. Lorsque les conditions d'illumination évoluent, il y a évolution de la tension sur la deuxième électrode du photodétecteur (figure 4e). Plus le photodétecteur est éclairé et plus l'écart à la tension appliquée sur la première borne est important.

Depuis le début de la durée d'intégration jusqu'à l'instant $t_2$, la tension appliquée sur la borne de sortie 8 correspond au courant intégré comme dans le cas de la courbe A. A partir de l'instant $t_2$, les conditions de polarisation du photodétecteur changent et la tension en sortie $V_8$ correspond à la tension présente sur la deuxième borne du photodétecteur. Ainsi, si les conditions d'illumination évoluent après l'instant $t_2$, il y a évolution de la tension de sortie $V_8$.

## Revendications

1. Dispositif de détection de rayonnement électromagnétique comportant :

   - un photodétecteur (1) muni de deux bornes,
   - un circuit de commande (3) configurée pour convertir le courant émis par le photodétecteur (1) en une première grandeur électrique au moyen d'une charge (5),
   - un pixel comportant le photodétecteur (1) et le circuit de commande (3), le pixel étant muni d'une borne de sortie (8) destinée à être reliée à un circuit d'analyse (4),

   dispositif **caractérisé en ce qu'**il comporte:

   - un circuit (2, 3, 6, 7) de polarisation du photodétecteur (1) configuré pour appliquer une première différence de potentiel aux bornes du photodétecteur (1) dans une première condition de fonctionnement ou pour qu'une des bornes du photodétecteur soit à un potentiel flottant dans une deuxième condition de fonctionnement,
   - un circuit de connexion/déconnexion (6, 7) du circuit de commande (3) avec la borne de sortie (8) du pixel et avec le photodétecteur (1) configuré pour connecter le circuit de commande (3) lorsque le photodétecteur (1) est dans le premier mode de fonctionnement et déconnecter le circuit de commande (3) lorsque le photodétecteur (1) est dans le deuxième mode de fonctionnement,
   - un interrupteur (9) reliant le photodétecteur (1) à la borne de sortie (8) du pixel configuré pour être à l'état bloquant lorsque le photodétecteur (1) est dans le premier mode de fonctionnement et pour être à l'état passant lorsque le photodétecteur (1) est dans le deuxième mode de fonctionnement,
   - un comparateur (10) de la tension aux bornes de la charge (5) par rapport à une valeur seuil ($V_{SEUIL}$) et délivrant un premier signal ou un deuxième signal en fonction de la comparaison, le comparateur (10) étant relié au circuit (6, 7) de connexion/déconnexion et à l'interrupteur (9).

2. Dispositif selon la revendication 1, **caractérisé en ce que** le comparateur (10) est configuré de manière à ce que le circuit de commande (3) soit relié au photodétecteur et à la borne de sortie (8) du pixel tant que la tension aux bornes de la charge (5) n'a pas atteint la valeur seuil ($V_{SEUIL}$) et que le photodétecteur (1) soit connecté à la borne de sortie (8) du pixel lorsque la tension aux bornes de la charge (5) atteint la valeur seuil.

3. Dispositif selon l'une des revendications 1 et 2, **caractérisé en ce que** le circuit (6, 7) de connexion/déconnexion comporte un premier interrupteur (6) connecté entre le photodétecteur (1) et le circuit de commande (3).

4. Dispositif selon l'une des revendications 1 et 2, **caractérisé en ce que** le circuit de commande (3) est à injection directe avec un transistor de polarisation (11) ayant une première borne connectée au photodétecteur (1) et une seconde borne connectée à la charge (5), le transistor de polarisation forme une partie du circuit (6, 7) de connexion/déconnexion, une électrode de grille du transistor de polarisation (11) étant reliée au comparateur (10).

5. Dispositif selon l'une quelconque des revendications 1 à 4, **caractérisé en ce que** le circuit (6, 7) de connexion/déconnexion comporte un deuxième interrupteur (7) connecté entre le circuit de commande (3) et la borne de sortie (8) du pixel.

6. Dispositif selon l'une quelconque des revendications 1 à 5, **caractérisé en ce que** la charge (5) est capacitive et comporte un condensateur d'intégration ($C_{INT}$) ayant une première borne connectée à un circuit imposant un potentiel fixe et **en ce que** le comparateur (10) est connecté à une deuxième borne du condensateur d'intégration ($C_{INT}$).

7. Dispositif selon l'une quelconque des revendications 1 à 6, **caractérisé en ce que** le comparateur (10) comporte une borne de sortie reliée au circuit d'analyse (4) de manière à informer le circuit d'analyse (4) du mode de fonctionnement du photodétecteur (1).

**Patentansprüche**

1. Vorrichtung zum Erfassen von elektromagnetischer Strahlung, welche umfasst:

   - einen Fotodetektor (1), der mit zwei Klemmen ausgestattet ist,
   - einen Steuerschaltkreis (3), der konfiguriert ist, um den von dem Fotodetektor (1) abgegebenen Strom mittels einer Last (5) in eine erste elektrische Größe zu konvergieren,
   - eine Pixeleinrichtung, die den Fotodetektor (1) und den Steuerschaltkreis (3) enthält, wobei die Pixeleinrichtung mit einer Ausgangsklemme (8) ausgestattet ist, die dazu vorgesehen ist, mit einem Analyseschaltkreis (4) verbunden zu werden,

   **dadurch gekennzeichnet,**
   **dass** sie enthält:

   - einen Polarisationsschaltkreis (2, 3, 6, 7) zur Polarisierung des Fotodetektors (1), der dahingehend konfiguriert ist, dass in einem ersten Betriebszustand eine erste Potentialdifferenz an die Anschlussklemmen des Fotodetektors (1) angelegt wird, bzw. dass in einem zweiten Betriebszustand eine der Anschlussklemmen des Fotodetektors ein schwebendes Potential aufweiset,
   - einen Schaltkreis (6, 7) zur Kopplung/Entkopplung des Steuefsehaltkieises (3) mit der Ausgangsklemme (8) der Pixeleinrichtung und mit dem Fotodetektor (1), der konfiguriert ist, um den Steuerschaltkreis (3) einzuschalten, wenn sich der Fotodetektor (1) im ersten Betriebsmodus befindet, und den Steuerschaltkreis (3) auszukoppeln, wenn sich der Fotodetektor (1) im zweiten Betriebsmodus befindet,
   - einen Unterbrecher (9), der den Fotodetektor (1) mit der Ausgangsklemme (8) der Pixelrichtung verbindet und so konfiguriert ist, dass er sich in Sperrzustand befindet, wenn sich der Fotodetektor (1) im ersten Betriebsmodus befindet, und sich im Durchlasszustand befindet, wenn sich der Fotodetektor (1) im zweiten Betriebsmodus befindet,

   - einen Komparator (10) zum Vergleichen der Spannung an den Anschlussklemmen der Last (5) mit einem Schwellenwert ($V_{seuil}$), der in Abhängigkeit von dem Vergleich ein erstes Signal oder ein zweites Signal abgibt, wobei der Komparator (10) mit dem Schaltkreis (6, 7) zur Kopplung/Entkopplung und mit dem Unterbrecher (9) verbunden ist.

2. Vorrichtung nach Anspruch 1,

   **dadurch gekennzeichnet,**
   **dass** der Komparator (10) dergestalt konfiguriert ist, dass der Steuerschaltkreis (3) mit dem Fotodetektor und mit der Ausgangsklemme (8) der Pixeleinrichtung verbunden ist, solange die Spannung an den Anschlussklemmen der Last (5) den Schwellenwert ($V_{seuil}$) nicht erreicht hat, und dass der Fotodetektor (1) und mit der Ausgangsklemme (8) der Pixeleinrichtung verbunden wird, sobald die Spannung an den Anschlussklemmen der Last (5) den Schwellenwert erreicht.

3. Schaltkreis Vorrichtung nach einem der Ansprüche 1 und 2,

   **dadurch gekennzeichnet,**
   **dass** der Kopplung/Entkopplungs-Schaltkreis (6, 7) einen ersten Unterbrecher (6) enthält, der zwischen dem Fotodetektor (1) und dem Steuerschaltkreis (3) geschaltet ist.

4. Vorrichtung nach einem der Ansprüche 1 und 2,

   **dadurch gekennzeichnet,**
   **dass** der Steuerschaltkreis (3) ein Schaltkreis mit Direktinjektion mit einem Polarisationstransistor (11) ist, der eine erste Klemme hat, die mit dem Fotodetektor (1) verbunden ist und eine zweite Klemme hat, die mit der Last (5) verbunden ist, wobei der Polarisationstransistor einen Teil des Kopplung/Entkopplungs-Schaltkreises (6, 7) bildet, wobei eine Gitterelektrode des Polarisationstransistors (11) mit dem Komparator (10) verbunden ist.

5. Vorrichtung nach einem der Ansprüche 1 bis 4,

   **dadurch gekennzeichnet,**
   **dass** der Kopplung/Entkopplungs-Schaltkreis (6, 7) einen zweiten Unterbrecher (7) enthält, der zwischen dem Steuerschaltkreis (3) und der Ausgangsklemme (8) der Pixeleinrichtung geschaltet ist.

6. Vorrichtung nach einem der Ansprüche 1 bis 5,

**dadurch gekennzeichnet,**
**dass** die Last (5) kapazitiv ist und einen Integrationskondensator ($C_{int}$) enthält, der eine erste Klemme hat, die mit einem Schaltkreis verbunden ist, der eine konstante Spannung anlegt, und dass der Komparator (10) mit einer zweiten Klemme des Integrationskondensators ($C_{int}$) verbunden ist.

7. Vorrichtung nach einem der Ansprüche 1 bis 6,

   **dadurch gekennzeichnet,**
   **dass** der Komparator (10) eine Ausgangsklemme aufweist, die mit dem Analyseschaltkreis (4) verbunden ist, so dass der Analyseschaltkreis (4) Information bezüglich des Betriebsmodus des Fotodetektors (1) erhält.

**Claims**

1. Device for detecting electromagnetic radiation comprising:

   - a photodetector (1) provided with two terminals,
   - a control circuit (3) configured for converting the current issued by the photodetector (1) into a first electrical variable by means of a load (5),
   - a pixel including the photodetector (1) and the control circuit (3), the pixel being provided with an output terminal (8) designed to be connected to an analysis circuit (4),

   device **characterized in that** it comprises :

   - A biasing circuit (2, 3, 6, 7) of the photodetector (1) configured to apply a first potential difference across the terminals of the photodetector (1) in a first operating condition and configured so that one of the terminals of the photodetector is at a floating potential in a second operating condition,
   - A circuit for connecting/disconnecting the control circuit (3) with the output terminal (8) of the pixel and with the photodetector (1) configured to connect the control circuit (3) when the photodetector (1) is in the first operating mode, and configured to disconnect the control circuit (3) when the photodetector (1) is in the second operating mode,
   - A switch (9) connecting the photodetector (1) to the output terminal (8) of the pixel and configured to be in the blocking state when the photodetector (1) is in the first operating mode and to be in the passing state when the photodetector (1) is in the second operating mode,
   - A comparator (10) of the voltage across the load (5) with respect to a threshold value ($V_{threshold}$) and configured to deliver a first signal or a second signal according to the comparison, the comparator (10) being connected to the circuit (6, 7) for connecting / disconnecting (6, 7) and to the switch (9).

2. Device according to claim 1, **characterized in that** the comparator (10) is configured so that the control circuit (3) is connected to the photodetector and to the output terminal (8) of the pixel as long as the voltage across the terminals of the load (5) has not reached the threshold value ($V_{threshold}$) and so that the photodetector (1) is connected to the output terminal (8) of the pixel when the voltage across the terminals of the load (5) reaches the threshold value.

3. Device according to one of claims 1 and 2, **characterized in that** the circuit (6, 7) for connecting / disconnecting comprises a first switch (6) connected between the photodetector (1) and the control circuit (3).

4. Device according to one of claims 1 and 2, **characterized in that** the control circuit (3) is a direct injection circuit with a biasing transistor (11) having a first terminal connected to the photodetector (1) and a second terminal connected to the load (5), the biasing transistor (11) forms a part of the circuit (6, 7) for connecting / disconnecting, a gate electrode of the biasing transistor (11) being connected to the comparator (10).

5. Device according to any one of claims 1 to 4, **characterized in that** the circuit(6, 7) for connecting / disconnecting comprises a second switch (7) connected between the control circuit (3) and the output terminal (8) of the pixel.

6. Device according to any one of claims 1 to 5, **characterized in that** the load (5) is a capacitive load and comprises an integrating capacitor ($C_{INT}$) having a first terminal connected to a circuit configured for applying a fixed potential on the first terminal and **in that** the comparator (10) is connected to a second terminal of the integrating capacitor ($C_{INT}$).

7. Device according to any one of claims 1 to 6, **characterized in that** the comparator (10) comprises an output terminal connected to the analysis circuit (4) and configured for informing the analysis circuit (4) of the operating mode of the photodetector (1).

Figure 1

Figure 2

Figure 3

Figure 4a

Figure 4b

Figure 4c

Figure 4d

Figure 4e

Figure 4f

14

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2302341 A

**Littérature non-brevet citée dans la description**

- **ZANOLLA et al.** *IEEE Transactions on Electron Devices,* Mai 2010, vol. 57 (5), 1119-1127